Europäisches Patentamt

European Patent Office

Office européen des brevets

(19)

(11) Publication number: **0 366 208**
**A2**

# (12) EUROPEAN PATENT APPLICATION

(21) Application number: **89202692.3**

(22) Date of filing: **26.10.89**

(51) Int. Cl.5: **H01L 21/18**

(30) Priority: **28.10.88 IT 662288**

(43) Date of publication of application:
**02.05.90 Bulletin 90/18**

(84) Designated Contracting States:
**DE FR GB NL**

(71) Applicant: **SGS-THOMSON
MICROELECTRONICS s.r.l.
Via C. Olivetti, 2
I-20041 Agrate Brianza Milano(IT)**

(72) Inventor: **Ronsisvalle, Cesare
Via Argo 22
I-95126 Catania CT(IT)**

(74) Representative: **Arena, Giovanni
Viale Certosa 135
I-20151 MIlano(IT)**

(54) **Method for bonding silicon wafers together, for manufacturing semiconductor devices.**

(57) After having polished the surfaces of the wafers to be bonded, decontaminated them and placed them together with their polished surfaces in close contact, and before the usual nitrogen thermal bonding treatment, they are placed in a vacuum chamber in which a sufficient degree of vacuum is obtained to completely remove any air remaining between the pairs of surfaces to be bonded.

EP 0 366 208 A2

## METHOD FOR BONDING SILICON WAFERS TOGETHER, FOR MANUFACTURING SEMICONDUCTOR DEVICES.

### Field of the Invention

The invention concerns an SDB (Silicon Direct Bonding) method consisting of bonding silicon wafers together in order to obtain a resulting wafer capable of replacing the one which, in the manufacture of semiconductor devices, is obtained by growing one or more epitaxial layers on a silicon substrate.

### Background of the Invention

The SDB or silicon wafer direct bonding technique offers the possibility of obtaining either SOS (Silicon On Silicon) structures or SOI (Silicon On Insulator) structures, and is described for example in the following publications:
- H. Ohashi et al. - "Study of Si-Wafer directly bonded interface effect on Power Device Characteristics" -pag. 678 - IEDM 87;
- J.B. Lasky - "Wafer Bonding for SOI technologies" -Appl. Phys. Lett. 48 (1), 6 January 1986;
- H. Ohashi et al. "Improved dielectrically isolated device integration by SDB technique" - pag. 210 IEDM 86;
- A. Nagakawa et al. "1800V bipolar mode MOSFETS: a first application of SDB technique to a power device" - pag. 222 IEDM 86;
- Toshiba Patent Application JP 6222112 filed on 24.03.86.

With SOS type structures it is possible to replace a number of epitaxial growths and, moreover, to obtain doping profiles with more abrupt variations.

With structures of the SOI type (obtained by bonding silicon wafers with at least one of their two surfaces oxidized) it is possible to obtain structures with embedded oxide, thus making it possible to produce, for example, dielectric insulations for high voltage integrated circuits or for monolithic power devices.

According to the known technique previously referred to, the bonding method comprises the following steps :

A) specular polishing of the surfaces of the wafers to be bonded;

B) decontamination of the polished wafers in such a way as to eliminate any type of contaminant whatsoever or any foreign particles (during the decontamination process the wafers are subsequently immersed in a $H_2SO_4$-$H_2O_2$ mixture, an HF solution, deionized water, and are then dried);

C) positioning of the wafers in a clean atmosphere with their polished surfaces in close contact with one another, at ambient temperature and atmospheric pressure, so as to prevent the accidental introduction of foreign particles between the surfaces of the wafers to be bonded together;

D) nitrogen thermal bonding at temperatures ranging from 1000 to 1250° C;

E) reduction in thickness of the bonded wafers so as to obtain substrates of the desired dimensions.

One problem which is very often encountered in carrying out the process previously described is the formation of non-bonded areas along the bonding surface of the wafers. This may be due to the presence of nitrogen (N) in the interface of the wafers subjected to thermal treatment; at temperatures nearing 1000° C, in fact, the nitrogen links with the silicon atoms, forming N-Si compounds which inhibit the formation of bonding links and consequently reduce the quality of the bonding.

### Object of the Invention

The purpose of this invention is to obviate the aforementioned problem.

### Summary of the Invention

For this purpose the invention provides a further step after the aforesaid step C and before step D, in which the wafers are placed in a vacuum chamber with a sufficient degree of vacuum to remove any air remaining trapped between the pairs of surfaces to be bonded.

### Specific Description

The features of the invention will be more clearly evident from the following example of a non-restrictive embodiment. According to this example, the wafers to be bonded are first subjected to the steps referred to in the aforesaid points A, B and C.

They are then pre-arranged in pairs in a basket and placed in a vacuum chamber. A vacuum is created in the chamber so as to bring the pressure to P < 10-7 torr, so that any air remaining trapped between the surfaces of the wafers is completely eliminated. The wafers are subsequently brought back to atmospheric pressure. Under such conditions the atmospheric pressure presses the pairs of wafers together thus preventing any further infiltration of air (and consequently of nitrogen) between the faying surfaces.

The process continues with the aforesaid steps D and E. Thermographic analyses carried out on the bonds obtained according to this invention have shown that by means of the process it is possible to achieve bonds distributed without interruption over the entire surface of the wafers in contact, with a consequent considerable increase in the efficiency of the process.

The method described may be used for bonding together two wafers, each consisting of monocrystalline silicon, or for bonding two wafers, one consisting of monocrystalline silicon and the other of silicon with an overlying layer of polycrystalline silicon.

It may also be used for bonding together silicon wafers with one or both of the surfaces to be bonded oxidized, in order to produce SOI type structures.

## Claims

1. Method for bonding silicon wafers together, for manufacturing semiconductor devices, comprising the following consecutive steps :
a) specular polishing of the surfaces of the wafers to be bonded;
b) decontamination of the polished wafers;
c) positioning of the wafers in a clean atmosphere with their polished surfaces in close contact with one another;
d) nitrogen thermal bonding;
characterized by the fact that between the aforesaid steps c) and d) the following further steps are carried out:
- placing the wafers to be bonded in a vacuum chamber and creating a sufficient level of vacuum L to completely remove any traces of air remaining between the pairs of surfaces to be bonded;
- subsequently returning the pressure on the wafers to its initial value.

2. Bonding method as claimed in Claim 1, characterized by the fact that the pressure P relative to the aforesaid level of vacuum is lower than 10-7 torr.